# EUROPEAN PATENT APPLICATION

(11) **EP 4 651 664 A1**
(43) Date of publication of application: **19.11.2025**
(21) Application number: 23937030.7
(22) Date of filing: 17.05.2023
(51) Int. Cl.: H10B 12/00

(54) **SEMICONDUCTOR STRUCTURE AND MANUFACTURING METHOD THEREFOR, MEMORY, AND MEMORY SYSTEM**

(71) Applicant: Yangtze Memory Technologies Co., Ltd., Wuhan, Hubei 430205 (CN)
(72) Inventor: CHEN, Liang, Wuhan, Hubei 430205 (CN); LIU, Zichen, Wuhan, Hubei 430205 (CN); WANG, Yanhong, Wuhan, Hubei 430205 (CN); LIU, Yaqin, Wuhan, Hubei 430205 (CN); LIU, Wei, Wuhan, Hubei 430205 (CN)
(74) Representative: Gramm, Lins & Partner Patent- und Rechtsanwälte PartGmbB
(86) International application number: PCT/CN2023/094901
(87) International publication number: WO 2024/234349

(57) **Abstract**

A semiconductor structure, a fabrication method thereof, a memory and a memory system are provided. The method includes: forming a plurality of capacitor holes extending through a stack of layers in the first region and the second region of the stack of layers; forming a first electrode layer over the inside walls of the respective capacitor holes; forming a dielectric layer over the stack of layers; removing at least part of the dielectric layer in the second region; and forming a second electrode layer, the portion of the second electrode layer in the first region being separated from the portion of the second electrode layer in the second region, and in the second region the first electrode layer being connected with the second electrode layer.

## Description

### TECHNICAL FIELD

The present application relates to the field of semiconductor technology, and in particular to a semiconductor structure, a fabrication method thereof, a memory and a memory system.

### BACKGROUND

Dynamic random access memories (DRAMs) are a type of semiconductor memory device. A DRAM consists of a number of duplicated memory cells, each of which includes a capacitive structure configured to store charge. The capacitive structure can influence the storage capacity of the DRAM.

In an existing DRAM, capacitive structures are usually located in the core region. However, fabrication of capacitor holes in the core region is prone to serious effect of etching load, which can degrade the reliability of the capacitive structures.

### SUMMARY

The present application provides a semiconductor structure, a fabrication method thereof, a memory and a memory system, which can reduce the effect of etching load in the core region during fabrication of capacitor holes and improve reliability of the capacitive structures.

In one aspect, examples of the present application provide a method of fabricating a semiconductor structure, the method including:
forming a plurality of capacitor holes extending through a stack of layers in the stacking direction, the stack of layers including a first region and a second region, and the plurality of capacitor holes being located in the first region and the second region;
forming a first electrode layer over the inside walls of the respective capacitor holes;
forming a dielectric layer on a side of the stack of layers in both the first region and the second region;
removing at least part of the dielectric layer in the second region; and
forming a second electrode layer in both the first region and the second region, the portion of the second electrode layer in the first region being separated from the portion of the second electrode layer in the second region, and in the second region the first electrode layer being connected with the second electrode layer.

In another aspect, examples of the present application provide a semiconductor structure that includes:
a stack structure including a first region and a second region;
a first electrode layer located in the first region and the second region, the first electrode layer extending through the stack structure in the stacking direction and being separated into individual portions;
a dielectric layer located at least in the first region; and
a second electrode layer located in both the first region and the second region, the portion of the second electrode layer in the first region being separated from the portion of the second electrode layer in the second region, in the second region the first electrode layer being connected with the second electrode layer, and the first electrode layer in the first region and the second electrode layer in the first region having the dielectric layer disposed therebetween.

In another aspect, examples of the present application further provide a memory including any of the semiconductor structures described above and a peripheral circuit structure electrically connected with the semiconductor structure.

In yet another aspect, examples of the present application further provide a memory system, the memory system including: at least one memory described above and a controller coupled with the at least one memory and configured to control data storage thereof.

In the semiconductor structure, the fabrication method thereof, the memory and the memory system provided by examples of the present application, a plurality of capacitor hole are formed to extend through a stack of layers in the stacking direction, the stack of layers includes a first area and a second area, and the plurality of capacitor holes are distributed in both the first area and the second area, so that serious effect of etching load may be prevented from occurring in the first region during formation of the capacitor holes, and the uniformity in size of the capacitor holes in the first region can be ensured as much as possible, avoiding under etching; and subsequently, a first electrode layer is formed over the inside walls of the capacitor holes, a dielectric layer is formed on a side of the stack of layers in the first region and the second region, and then is at least partially removed in the second region, and a second electrode layer is formed in the first region and the second region, with the portion of the second electrode layer in the first region separated from the portion of the second electrode layer in the second region, and the first electrode layer in the second region connected with the second electrode layer in the second region, so that capacitive structures that are uniform in size can be formed in the first region to improve their reliability.

### BRIEF DESCRIPTION OF DRAWINGS

In order to explain technical solutions in examples of the present application more clearly, accompanying drawings required for describing the examples will be described briefly hereafter. It is obvious that the drawings described below are only some examples of the present application and other drawings can be obtained by those skilled in the art according to those drawings without any creative work.
Fig. 1 is a flowchart illustrating a method of fabricating a semiconductor structure provided by an example of the present application;
Figs. 2A to 2J are cross-sectional structural diagrams of a semiconductor structure provided by an example of the present application at different process operations;
Fig. 3A is a cross-sectional structural diagram taken along the C1-C1 line in Fig. 2D;
Fig. 3B is a cross-sectional structural diagram taken along the C2-C2 line in Fig. 2E;
Fig. 3 C is a cross-sectional structural diagram taken along the C3-C3 line in Fig. 2F;
Fig. 3D is a cross-sectional structural diagram taken along the C4-C4 line in Fig. 2G;
Fig. 3E is a cross-sectional structural diagram taken along the C5-C5 line in Fig. 2H;
Fig. 3F is a cross-sectional structural diagram taken along the C6-C6 line in Fig. 2I;
Fig. 3G is a cross-sectional structural diagram taken along the C7-C7 line in Fig. 2J;
Figs. 4A to 4H are some other cross-sectional structural diagrams of a semiconductor structure provided by an example of the present application at different process operations;
Fig. 5A is a cross-sectional structural diagram taken along the D1-D1 line in Fig. 4A;
Fig. 5B is a cross-sectional structural diagram taken along the D2-D2 line in Fig. 4B;
Fig. 5C is a cross-sectional structural diagram taken along the D3-D3 line in Fig. 4C;
Fig. 5D is a cross-sectional structural diagram taken along the D4-D4 line in Fig. 4D;
Fig. 5E is a cross-sectional structural diagram taken along the D5-D5 line in Fig. 4E;
Fig. 5F is a cross-sectional structural diagram taken along the D6-D6 line in Fig. 4F;
Fig. 5G is a cross-sectional structural diagram taken along the D7-D7 line in Fig. 4G;
Fig. 5H is a cross-sectional structural diagram taken along the D8-D8 line in Fig. 4H;
Fig. 6A is a cross-sectional structural diagram of another semiconductor structure provided by an example of the present application;
Fig. 6B is a cross-sectional structural diagram taken along the d-d line in Fig. 6A;
Fig. 7 is a structural diagram of a system provided by an example of the present application;
Fig. 8 is a structural diagram of a memory provided by an example of the present application;
Fig. 9 is a cross-sectional structural diagram of a memory provided by an example of the present application.

### DETAILED DESCRIPTION

The present application will be described in detail hereafter with reference to accompanying drawings and examples. It is particularly noted that the following examples are only used to illustrate the present application and not to define its scope. Likewise, the following examples are only some, not all, of the examples of the present application, and all other examples obtained by those of ordinary skills in the art without any creative work fall within the scope claimed by the present application.

In the description herein, it is understood that orientation and position relationships indicated by terms "center", "lateral", "upper", "lower", "left", "right", "vertical", "horizontal", "top", "bottom", "inner", "outer" and the like are those based on the drawings and only for the purpose of describing the present application and simplifying the description. There is no indication or implication that the devices or elements referred to must have any particular orientations and positions, or be constructed or operated in any particular orientations and positions. As a result, they should not be understood as limitation for the present application. Moreover, the terms "first", "second" etc. are only used for the purpose of description and should not be understood to indicate or imply relative importance or to designate the number of the referenced technical features implicitly. Therefore, a feature qualified by "first" or "second" may include explicitly or implicitly one or more instances of the feature.

In the description herein, it is noted that terms "mount", "interconnect" and "connect" should be explained broadly, unless otherwise specified or limited expressly. They include, for example, fixed connection, removable connection or integral connection; mechanical connection or electrical connection; direct interconnection or interconnection with intermediate medium; or inner communication of two elements. The specific meaning of the above-mentioned terms in the present application will be understood by those of ordinary skills in the art depending on specific circumstances.

It should be understood that the meaning of terms "on," "over," and "above" herein should be interpreted in the broadest manner such that "on" not only means "on" something without any intermediate feature or layer (i.e., directly on something) but also includes the meaning of "on" something with an intermediate feature or a layer therebetween.

Terms used herein are only for the purpose of describing examples without any intention of limiting them. Singular forms such as "a", "an", and "the" are also intended to include plural forms, unless otherwise noted in the context. The phrase "a plurality of" means two or more. It is also understood that terms "include" and/or "comprise" used herein designate existence of the stated features, integers, steps, operations, units and/or assemblies without excluding existence or addition of one or more other features, integers, steps, operations, units, assemblies and/or any combination thereof.

Examples of the present application provide a semiconductor structure, a fabrication method thereof, a memory and a memory system.

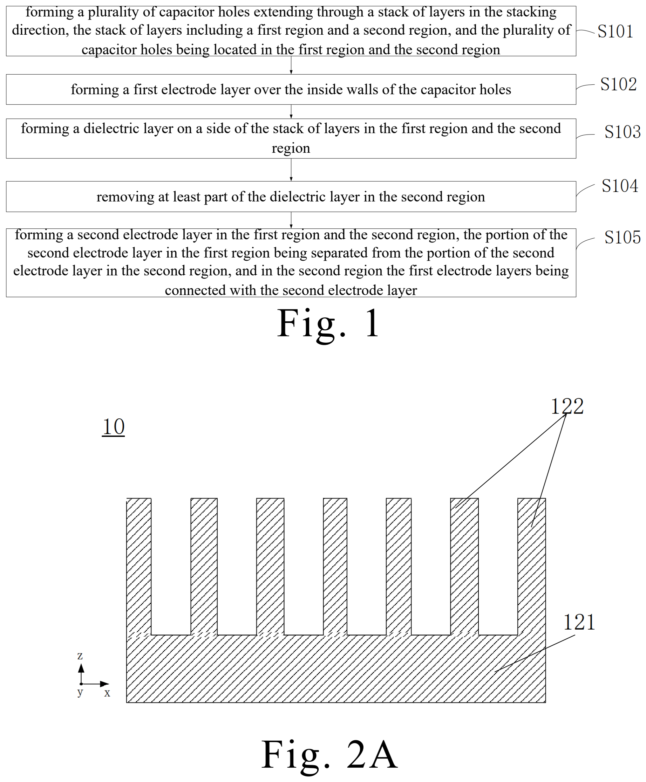

Refer to Fig. 1, which is a flowchart of a method of fabricating a semiconductor structure provided by an example of the present application. The method of fabricating a semiconductor structure may include the following operations S101-S105.

At operation S101, a plurality of capacitor holes extending through a stack of layers in the stacking direction are formed. The stack of layers includes a first region and a second region and the capacitor holes are located in both the first region and the second region.

At operation S102, a first electrode layer are formed over the inside walls of the respective capacitor holes.

At operation S103, a dielectric layer is formed on a side of the stack of layers in both the first region and the second region.

At operation S104, at least part of the dielectric layer in the second region is removed.

At operation S105, a second electrode layer is formed in both the first region and the second region, the portion of the second electrode layer in the first region being separated from the portion of the second electrode layer in the second region, and in the second region the first electrode layer being connected with the second electrode layer.

It should be understood that the operations shown in the above-described fabrication method are not exclusive and other operations may be performed before, after or between any one(s) of the shown operations.

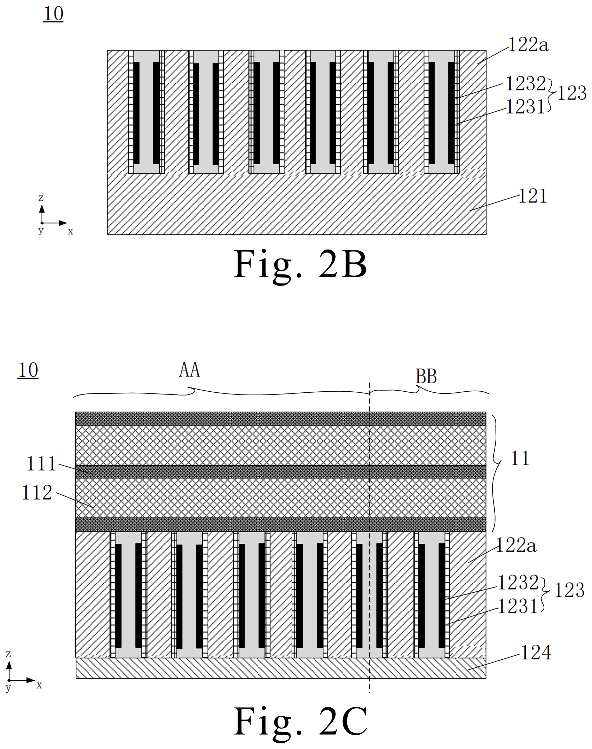

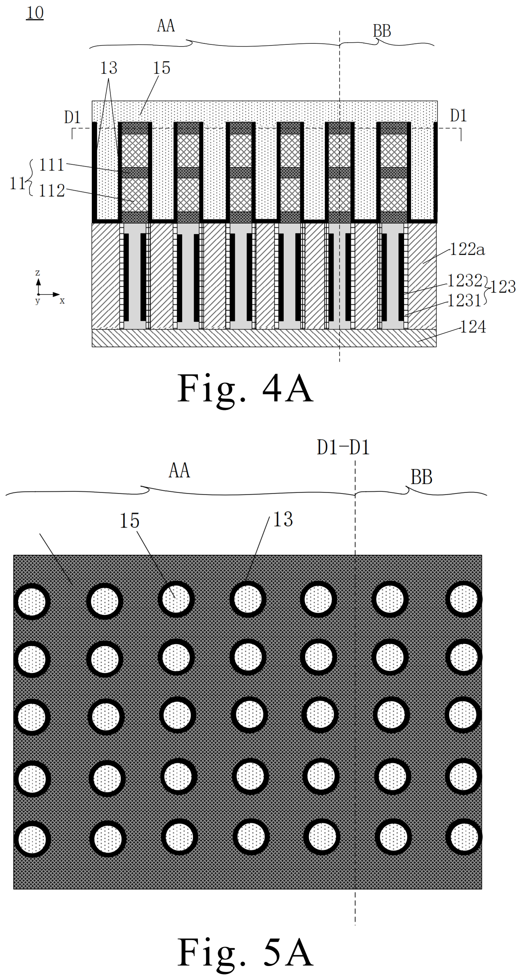

Refer to Figs. 2A to 2J, which are cross-sectional structural diagrams of a semiconductor structure 10 at different process operations provided by an example of the present application, and Figs. 4A to 4H, which are some other cross-sectional structural diagrams of a semiconductor structure 10 at different process operations provided by an example of the present application. The semiconductor structure 10 may include cup-type capacitive structures or pillar-type capacitive structures. The operations S101-S105 will be further described hereafter with reference to Figs. 2A to 2J and Figs. 4A to 4H.

At operation S101, a plurality of capacitor holes Q1 extending through a stack of layers 11 in the stacking direction z are formed. The stack of layers 11 includes a first region AA and a second region BB, and the capacitor holes Q1 are located in both the first region AA and the second region BB.

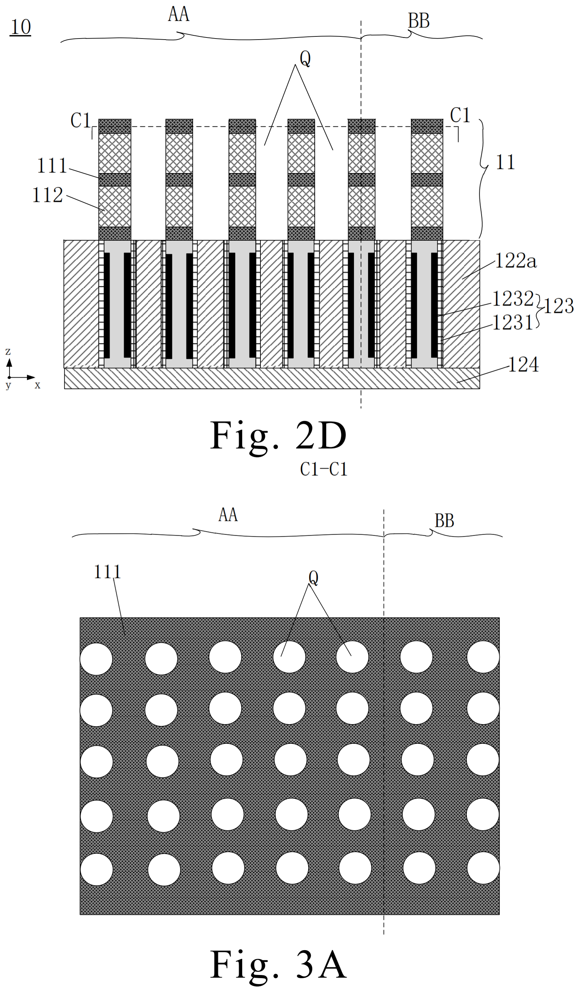

Here, if the semiconductor structure 10 includes cup-type capacitive structures or pillar-type capacitive structures, refer to the above-mentioned Figs. 2A to 2D and Fig. 3A, Fig. 3A being a cross-sectional structural diagram taken along the C1-C1 line in Fig. 2D. The first region AA is the region corresponding to a memory array and the second region BB is used for another purpose. They may adjoin each other, e.g., the second region BB surrounds the first region AA. The capacitor holes Q1 may be distributed throughout the stack of layers 11 and separated from each other. In an example, the capacitor holes Q1 may be disposed to have the same size and arranged at the same interval.

In an example, the stack of layers 11 may be formed using any suitable thin film deposition process such as chemical vapor deposition (CVD), physical vapor deposition (PVD), atomic layer deposition (ALD) or any combination thereof. The stack of layers 11 may be composed of alternating stacked layers of different materials, e.g., layers of silicon dioxide and layers of silicon nitride that are stacked alternately.

Two patterning processes that are performed orthogonally or at an angle with respect to each other may be used to form capacitor holes Q1 in both the first region AA and the second region BB of the stack of layers 11. Here, due to the relatively uniform distribution of patterns of the capacitor holes Q1 over the whole surface of the stack of layers 11, i.e., the relatively small difference in density of holes between the etching pattern in the first region AA and the etching pattern in the second region BB, the difference in etching depth and size between the capacitor holes Q1 formed in the first region AA and the capacitor holes Q1 formed in the second region BB will be relatively small finally, and serious effect of etching load may be avoided as much as possible. Moreover, even if the effect of etching load occurs to some degree to influence the etching depth and size of the capacitor holes Q1 at the periphery, the effect of etching load will only influence the outermost capacitor holes Q1 in the second region BB and can hardly influence the capacitor holes Q1 in the first region AA, because the second region BB surrounds the first region AA. Therefore, by forming capacitor holes Q1 in both the first region AA1 and the second region BB, serious effect of etching load can be avoided in the first region AA greatly to ensure the uniformity in etching depth and size of the capacitor holes Q1 in the first region AA, so that the phenomenon of some capacitor holes Q1 therein having insufficient etching depths or too small sizes will not occur.

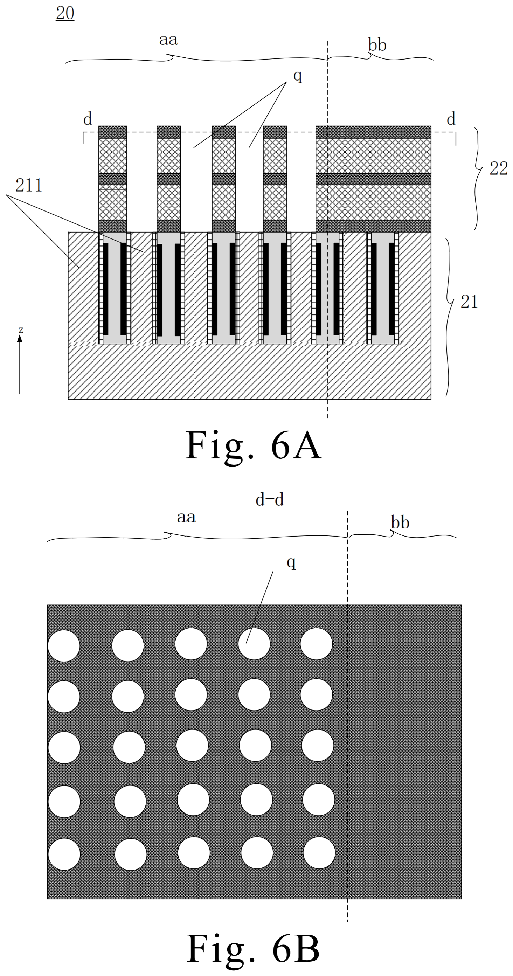

In some implementations, refer to Fig. 6A, which is a cross-sectional structural diagram of another semiconductor structure 20 provided by an example of the present application, and Fig. 6B, which is a cross-sectional structural diagram taken along the d-d line in Fig. 6A. Here, the semiconductor structure 20 includes a first stack structure 21 and a second stack of layers 22 located over the first stack structure 21. The first stack structure 21 includes channel structures 211 and the second stack of layers 22 includes a core region aa having capacitor holes q therein and a non-core region bb. In an example, the capacitor holes q can be formed directly in the core region aa and then a first electrode layer, a dielectric layer and a second electrode layer are fabricated to obtain the capacitive structures in the core region aa.

However, since no capacitor hole q is needed to be fabricated in the non-core region during fabrication of capacitor holes q, there is a large difference in density of holes between the etching pattern of the core region aa and the etching pattern of non-core region bb, and as a result serious effect of etching load may occur at the boundary between the core region aa and the non-core region bb, leading to obvious difference in etching depth and size between the capacitor holes q at the periphery of the core region aa and the capacitor holes q at the center of the core region aa. For example, the etching depths of the capacitor holes q at the periphery of the core region aa are too small to make the holes extend through the stack of layers 22 in the stacking direction z, and thus the capacitive structures formed finally at the periphery of the core region aa may fail to be electrically connected with the corresponding channel structures 211; or the sizes of those capacitor holes q are too small and affect subsequent formation of the corresponding capacitive structures and the reliability of those capacitive structures. However, the semiconductor structure 10 provided by examples of the present application solves the above-mentioned problems at least partially.

It is to be noted that, in the semiconductor structure 10 provided by examples of the present application, capacitive structures may be formed after formation of channel structures. That is, with continued reference to Figs. 2A to 2D, before the above-mentioned operation S101, the fabrication method may further include the operations of:
forming a plurality of active parts 122 extending in the first direction x and spaced at an interval in the second direction y on a substrate 121;
doping the active parts 122 corresponding to the second region BB with a first concentration;
forming gate structures 123 extending in the second direction y and connecting at least the active parts 122 in the first region AA, the gate structures 123 extending through the active parts in the stacking direction z and resulting in a plurality of channel structures 122a, the first direction x, the second direction y and the stacking direction z being perpendicular to each other; and
forming a stack of layers 11 on the side of the substrate 121 proximate to the channel structures 122a.

Here, if the semiconductor structure 10 includes cup-type capacitive structures or pillar-type capacitive structures, with continued reference to Figs. 2A to 2C, the substrate 121 may include at least one of single crystal silicon (Si), single crystal germanium (Ge), III-V compound semiconductor materials, II-VI compound semiconductor materials or any other semiconductor materials known in the art. The first direction x and the second direction y may be the directions, in which the stack of layers 11 extend, and are perpendicular to the stacking direction z of the stack of layers 11. Each of the gate structures 123 may include a gate spacer layer 1231 and a gate layer 1232. The gate spacer layer 1231 may include oxide or any other insulating material, and the gate layer 1232 may include any one or combination of tungsten, cobalt, copper, aluminum, polysilicon and doped crystal silicon.

In an example, the active parts 122 may be formed by etching the substrate 121 and the gate structures 123 adjacent in the first direction x may be separated and thus electrically insulated from each other by the insulating material filled therebetween. After the filling of the insulating material, the portion of the substrate 121 other than the active parts 122, i.e., the bottom portion of the substrate 121, may be removed and bit lines are fabricated to be connected with the channel structures 122a.

It is to be noted that gate structures 123 may be formed at corresponding locations in the first region AA and the second region BB (for example, as shown in the above-mentioned Figs. 2C and 2D) or only at corresponding locations in the first region AA and the present application is not limited in this respect. The active parts 122 corresponding to the second region BB may be doped, which aims mainly at increasing the conductivity of those active parts 122.

In some implementations, before formation of the gate structures 123, the fabrication method may further include: doping the active parts 122 in the first region AA with a second concentration that is lower than the first concentration. In some implementations, the doping can be performed after formation of the gate structures 123, i.e., doping the channel structures 122a with the second concentration.

Here, the active parts 122 (or the channel structures 122a) in the first region AA are doped mainly to increase the conductivity of the active parts (or the channel structures 122a) in the first region AA and thus form the corresponding source areas to be electrically connected with the capacitive structures to be formed subsequently.

At operation S102, a first electrode layer 13 is formed over the inside walls of the respective capacitor holes Q1.

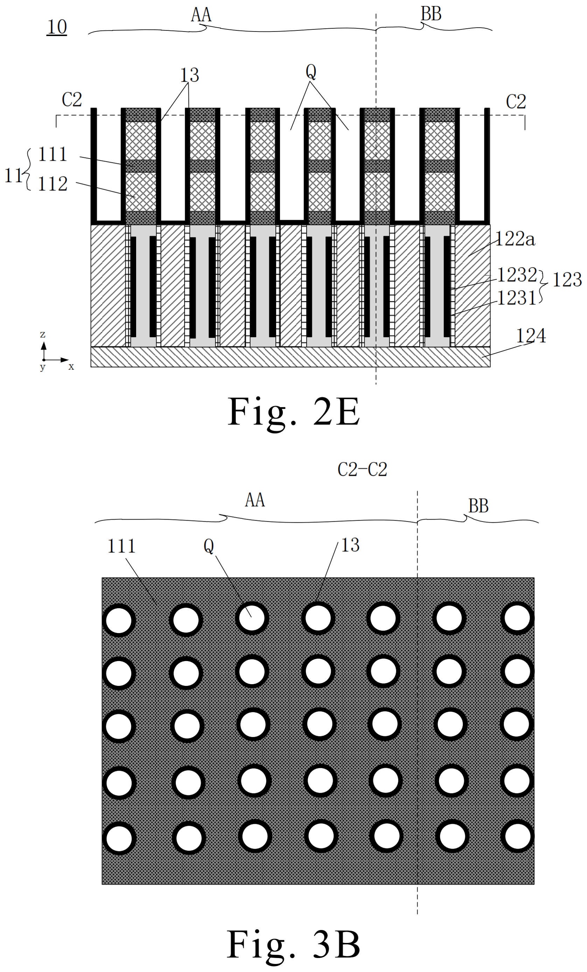

Here, if the semiconductor structure 10 includes cup-type capacitive structures or pillar-type capacitive structures, refer further to Fig. 2D, Fig. 2E and Fig. 3B, Fig. 3B being a cross-sectional structural diagram taken along the C2-C2 line in Fig. 2E. The first electrode layer 13 includes metal or any other conductive material, such as tungsten or copper. A layer of conductive material can be formed on a side of the stack of layers 11 and then the portions of the layer of conductive material outside the capacitor holes Q1 are removed to obtain the first electrode layer 13 located in the respective capacitor holes Q1.

It is to be noted that, since the capacitor holes Q1 in the first region AA are separated from each other and so are the capacitor holes Q1 in the second region BB, the first electrode layer 13 in the first region AA is separated and so is the first electrode layer 13 in the second region BB, i.e., the first electrode layer 13 in the first region AA and the first electrode layer 13 in the second region BB both include multiple segmented parts, which are disconnected to each other.

At operation S103, a dielectric layer 14 is formed on the side of the stack of layers 11 in both the first region AA and the second region BB.

Here, the material of the dielectric layer 14 have a high dielectric constant. For different types of capacitive structures, different operations may be taken to form the dielectric layer 14. The operations are mainly different in the specific location of the resulted dielectric layer in first region AA and the second region BB.

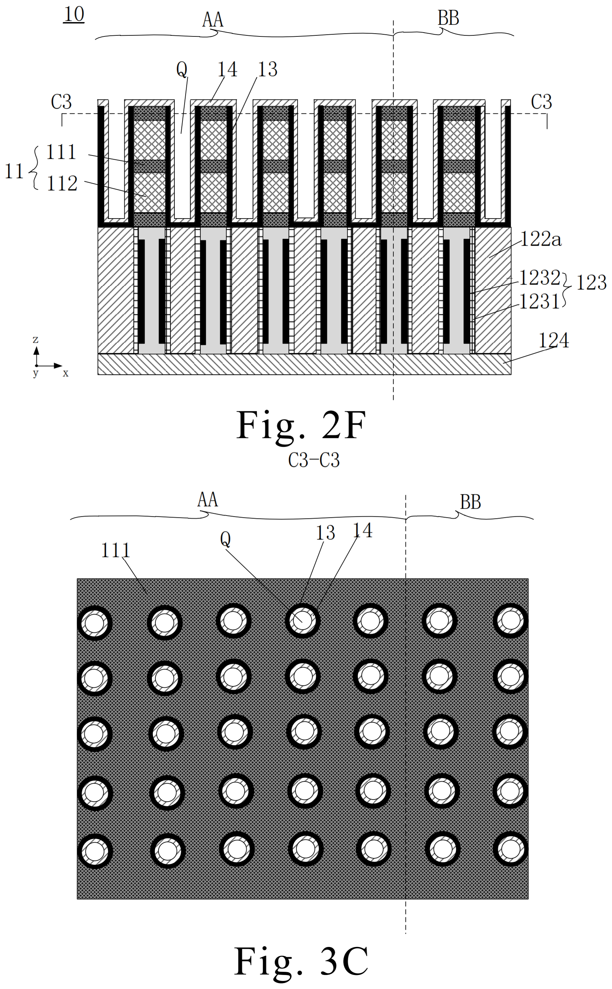

In some implementations, for example, if the semiconductor structure 10 includes cup-type capacitive structures, refer further to Fig. 2E, Fig. 2F and Fig. 3C, Fig. 3C being a cross-sectional structural diagram taken along the C3-C3 line in Fig. 2F. In an example, after formation of the first electrode layer 13, a dielectric layer 14 is formed to not only cover the first electrode layer 13 on the side away from the stack of layers 11 but also cover the top of the stack of layers 11.

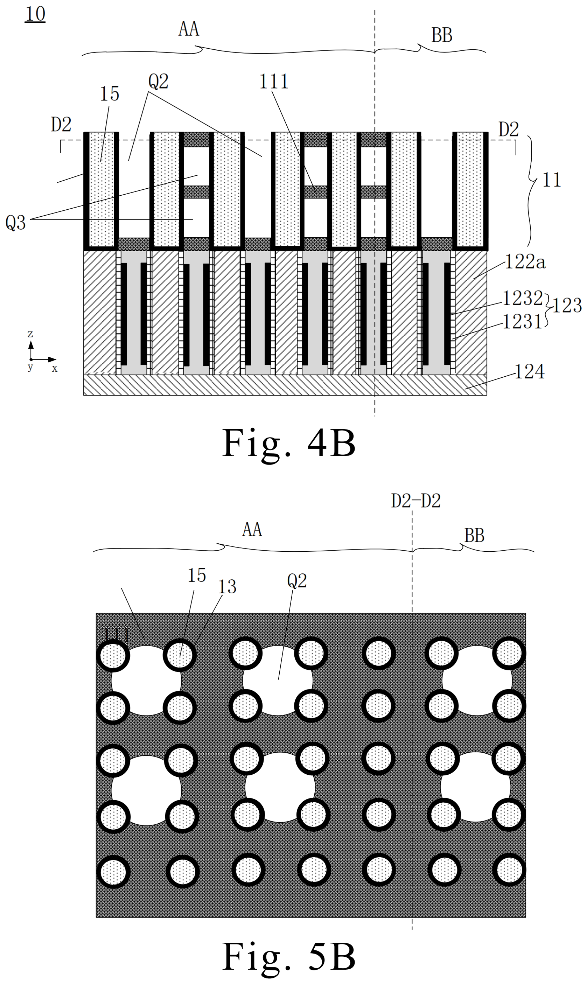

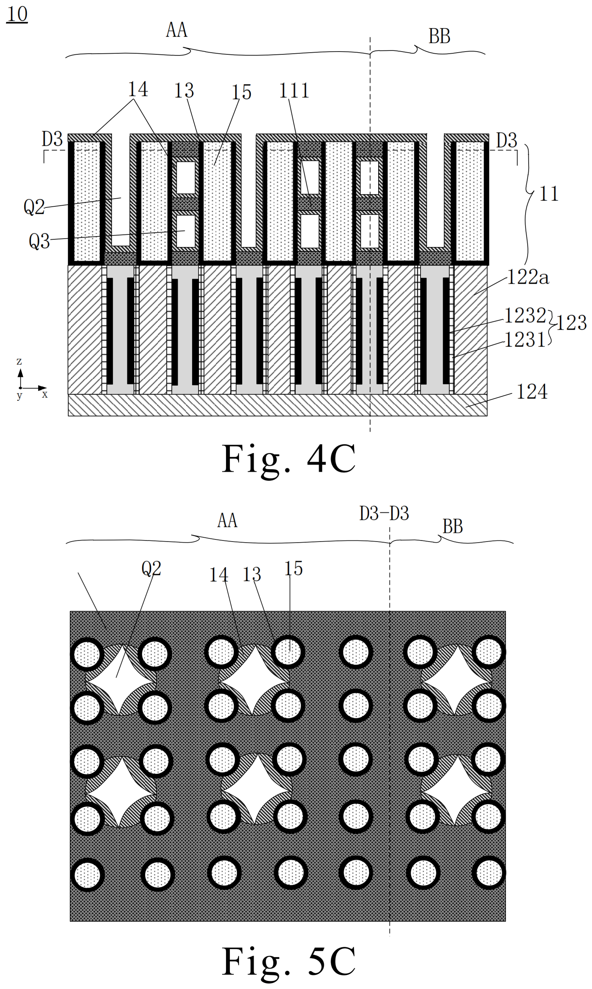

In some implementations, for example, if the semiconductor structure 10 includes pillar-type capacitive structures, refer to Figs. 4A to 4H, which are some other cross-sectional structural diagrams of a semiconductor structure 10 at different process operations provided by an example of the present application. Here, refer further to Fig. 2E, Figs. 4A to 4C and Figs. 5A to 5C. Fig. 5A is a cross-sectional structural diagram taken along the D1-D1 line in Fig. 4A, Fig. 5B is a cross-sectional structural diagram taken along the D2-D2 line in Fig. 4B and Fig. 5C is a cross-sectional structural diagram taken along the D3-D3 line in Fig. 4C. In an example, for pillar-type capacitive structures, after formation of the first electrode layer 13, the stack of layers 11 is partially removed and then the dielectric layer 14 is formed. That is, the stack of layers 11 may include sacrificial layers 112 and, before the above-mentioned operation S103, the fabrication method further includes:
forming a supporting layer 15 on the side of the stack of layers 11 in both the first region AA and the second region BB with the supporting layer 15 filling up the capacitor holes Q1;
forming a plurality of spacer holes Q2 extending through the supporting layer 15 into the stack of layers 11 in the stacking direction z, and removing the sacrificial layers 112 to form cavities Q3, the spacer holes being located in both the first region AA and the second region BB; and
removing the portions of the supporting layer 15 outside the capacitor holes Q1.

Here, the stack of layers 11 may include alternating spacer layers 111 and sacrificial layers 112. The sacrificial layers 112 may include silicon dioxide and the spacer layers 111 may include silicon nitride. The material of the supporting layer 15 is different from that of the stack of layers 11 and may include, for example, carbon. The supporting layer 15 not only fills up the capacitor holes Q1 but also cover the top of the stack of layers 11.

In an example, the spacer holes Q2 may be formed by multiple etching operations. For example, a pattern of holes corresponding to the spacer holes Q2 is formed through the supporting layer 15 and the adjacent spacer layer 111 using a mask; then the sacrificial layer 112 is removed through the pattern of holes by wet etching or dry etching to expose the underlying adjacent spacer layer 111 partially; subsequently, the exposed portions of the underlying spacer layer 111 are etched to expose the underlying adjacent sacrificial layer 112; and then the underlying sacrificial layer 112 is removed from the exposed locations. Through the multiple etching operations, all the sacrificial layers 112 in the stack of layers 11 are removed and only the spacer layer 111 at the bottom is left, so that spacer holes Q2 extending through the supporting layer 15 into the stack of layers 11 in the stacking direction z are obtained.

Meanwhile, during formation of the spacer holes Q2, the sacrificial layers 112 are removed by the way to obtain the cavities Q3. After formation of the spacer holes Q2 and the cavities Q3, the dielectric layer 14 is formed to not only be located on the stack of layers 11 (i.e., cover the top of the stack of layers 11) but also cover the inside walls of the cavities Q3 and the spacer holes Q2. It is to be noted that, during the process of removing the sacrificial layers 112 in the stack of layers 11, since the supporting layer 15 is filled into the capacitor holes Q1 to provide support, the stack of layers 11 will not collapse.

It is to be noted that only one cross section shape of each spacer hole Q2 (the shape of circle shown in the figures) and only one arrangement of the spacer holes Q2 are illustrated in the figures, while in other implementations the spacer holes Q2 may each have any other cross section shape (e.g., the shape of trapezoid) and be arranged in any other way. The present application is not limited in this respect. Furthermore, the spacer holes Q2 may be formed in any way other than the above-described multiple etching operations, e.g., in a single etching operation. The present application is not limited in this respect.

At operation S104, at least part of the dielectric layer 14 in the second region BB is removed.

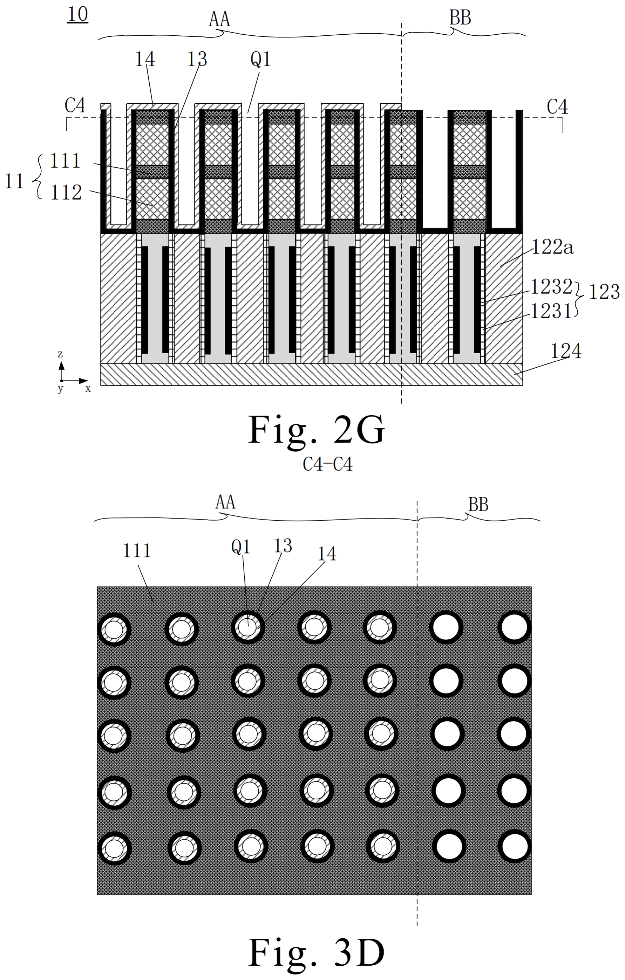

Here, for different capacitive structures, different operations may be taken to remove the dielectric layer 14. For example, if the semiconductor structure 10 includes cup-type capacitive structures, with continued reference to Fig. 2F, Fig. 2G and Fig. 3D (a cross-sectional structural diagram taken along the C4-C4 line in Fig. 2G), the above-mentioned operation S104 may for example include: removing the dielectric layer 14 in the second region BB and exposing the first electrode layer 13 in the second region BB.

In an example, for cup-type capacitive structures, the dielectric layer 14 in the second region BB may be removed completely through etching, i.e., the portions of the dielectric layer 14 on the top of the stack of layers 11 and in the capacitor holes Q1 in the second region BB are all removed, and meanwhile the first electrode layer 13 in the capacitor holes Q1 in the second region BB is exposed.

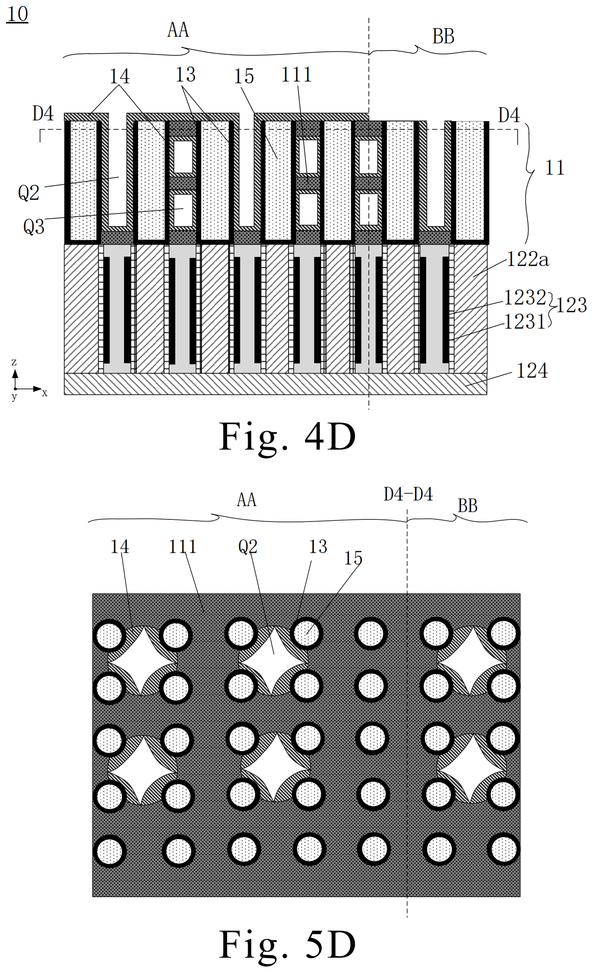

In some implementations, for example, if the semiconductor structure 10 includes pillar-type capacitive structures, with reference to Fig. 4C, Fig. 4D and Fig. 5D (a cross-sectional structural diagram taken along the D4-D4 line in Fig. 4D), the above-mentioned operation S104 may for example include: removing the portion of the dielectric layer 14 on the top of the stack of layers 11 in the second region BB and exposing a portion of the first electrode layer 13 in the second region BB.

In an example, for pillar-type capacitive structures, the dielectric layer 14 in the second region BB may be removed partially through etching, i.e. the portion of the dielectric layer 14 on the top of the stack of layers 11 in the second region BB is removed to expose the first electrode layer at the corresponding locations (at the tops) of the capacitor holes Q1, while the portions of the dielectric layer 14 on the inside walls of the cavities Q3 and the spacer holes Q2 are left without being removed.

At operation S105, a second electrode layer 16 is formed in the first region AA and the second region BB, the portion of the second electrode layer 16 in the first region AA is separated from the portion of the second electrode layer 16 in the second region BB and, in the second region BB, the first electrode layer 13 is connected with the second electrode layer 16.

Here, the first electrode layer 13, the dielectric layer 14 and the second electrode layer 16 together act as capacitive structures that can store charges. The second electrode layer 16 includes mainly a conductive material, such as any one or combination of tungsten, cobalt, copper, aluminum, polysilicon or doped crystal silicon. The portion of the second electrode layer 16 in the first region AA is separated from the portion of the second electrode layer 16 in the second region BB, which mainly means that the portion of the second electrode layer 16 in the first region AA is disconnected with the portion of the second electrode layer 16 in the second region BB, i.e., there is no contact area therebetween and they will be electrically insulated from each other when power is on later. In the second region BB the first electrode layer 13 is connected with the second electrode layer 16, which mainly means that first electrode layer 13 in the second region BB and the second electrode layer 16 in the second region BB are in direct contact at least in some areas and will be electrically connected with each other when power is on later.

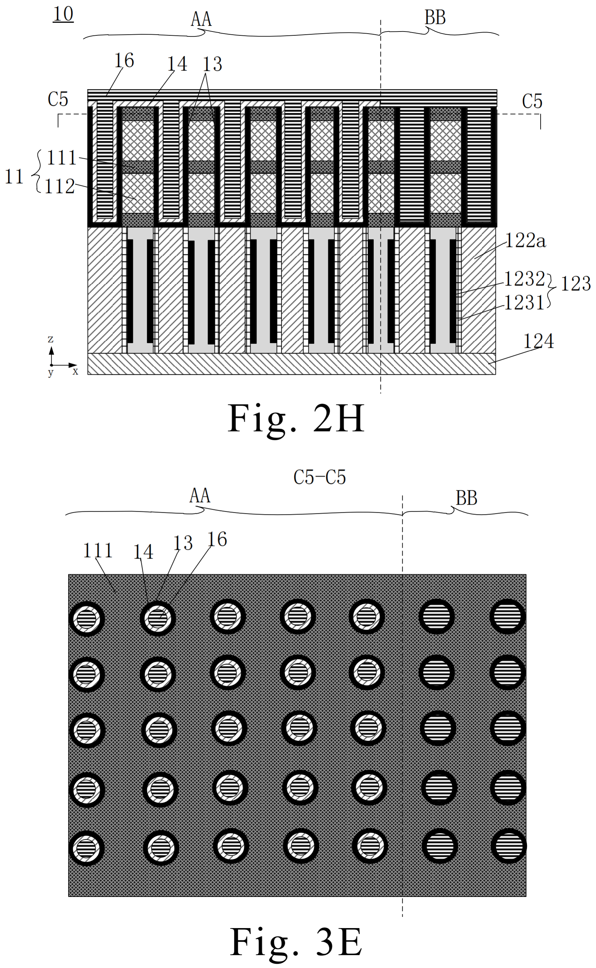

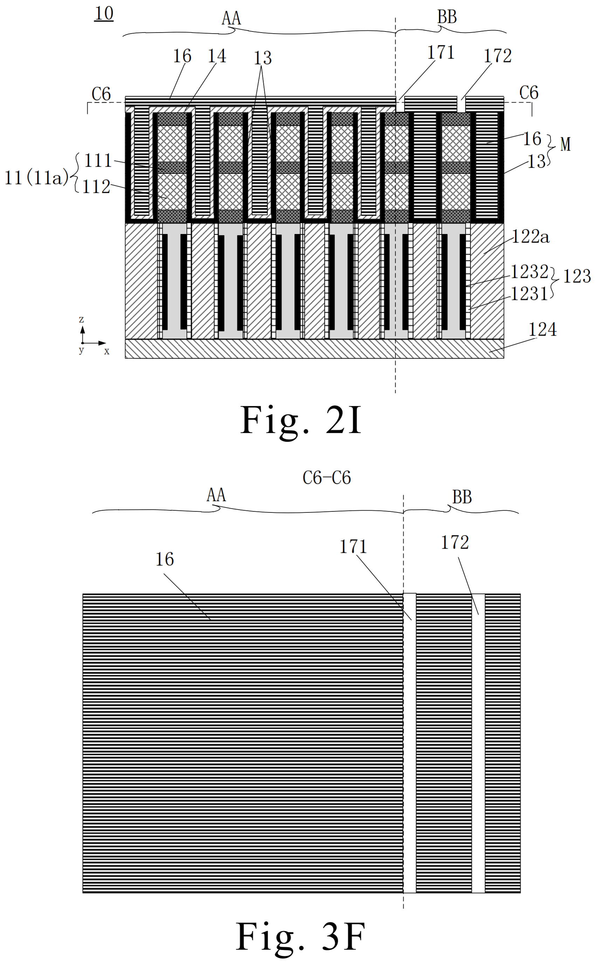

In an example, if the semiconductor structure 10 includes cup-type capacitive structures, with continued reference to Figs. 2G to 2I, Fig. 3E (a cross-sectional structural diagram taken along the C5-C5 line in Fig. 2H) and Fig. 3F (a cross-sectional structural diagram taken along the C6-C6 line in Fig. 2I), the above-mentioned operation S105 may include:
forming a second electrode layer 16 on the side of the stack of layers 11 in the first region AA and the second region BB, the second electrode layer 16 covering the dielectric layer 14 on the side away from the stack of layers 11 and the exposed first electrode layer 13 and filling up the capacitor holes Q1; and
forming a first trench 171 extending through the second electrode layer 16 on the stack of layers 11 in the stacking direction z and extending in the first direction x, the first trench 171 separating the portion of the second electrode layer 16 in the first region AA from the portion of the second electrode layer 16 in the second region BB in the second direction y, the first direction x, the second direction y and the stacking direction z being perpendicular to each other.

Here, for cup-type capacitive structures, since the dielectric layer 14 in the second region BB is removed completely, the first electrode layer 13 in the second region BB is exposed entirely, the second electrode layer 16 formed in the second region BB may be in contact and connected with the first electrode layer 13 in the second region BB entirely. When power is on later, the first electrode layer 13 and the second electrode layer 16 that are connected will be short-circuited and thus electrically connected. Meanwhile, the portion of the dielectric layer 14 in the first region AA is not removed, so that, in the first region AA, the first electrode layer 13 and the second electrode layer 16 may be separated from each other by the dielectric layer 14.

The first trench 171 is configured to separate the second electrode layer 16 into two disconnected portions, i.e., the portion of the second electrode layer 16 in the first region AA and the portion of the second electrode layer 16 in the second region BB, so that the two portions are separated and electrically insulated from each other. Here, the first trench may be correspondingly located at the boundary between the second region BB and the first region AA.

In some implementations, if the semiconductor structure 10 includes cup-type capacitive structures, with reference to Fig. 2H, Fig. 2I and Fig. 3F, the fabrication method may further include:
forming at least one second trench 172 extending, in the stacking direction z, through the portion of the second electrode layer 16 over the stack of layers 11 in the second region BB, the at least one second trench 172 separating the portion of the second electrode layer 16 in the second region BB into multiple portions.

Here, the second trench(es) 172 may be formed through etching and configured to separate the second electrode layer 16 in the second region BB into multiple portions, i.e., multiple portions of the second electrode layer 16 that are disconnected and may be controlled independently. The first trench 171 and the second trench(es) 172 may be formed in the same etching process or in different etching processes, and there is no limitation on the sequence in which they are formed.

Any one of the portions of the second electrode layer 16 formed by separating in the second region BB is connected with corresponding disconnected first electrodes 13. The first electrode layer 13 and the second electrode layer 16 that are connected as a whole may serve as a contact structure M, so that multiple contact structures M are obtained with each of them extending through the stack of layers 11 in the stacking direction z. The specific number and location(s) of the second trench(es) 172 may be determined based on the number and locations of the contact structures M to be fabricated. The present application is not limited in this respect.

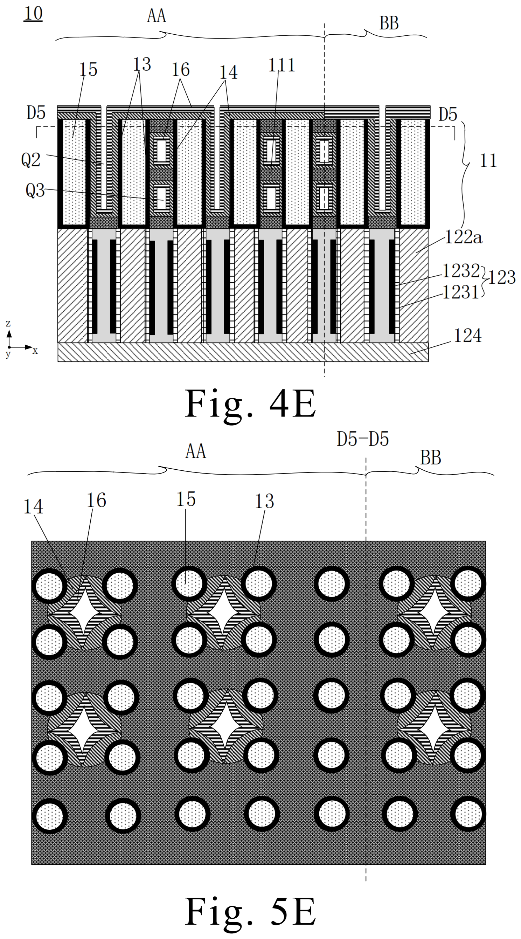

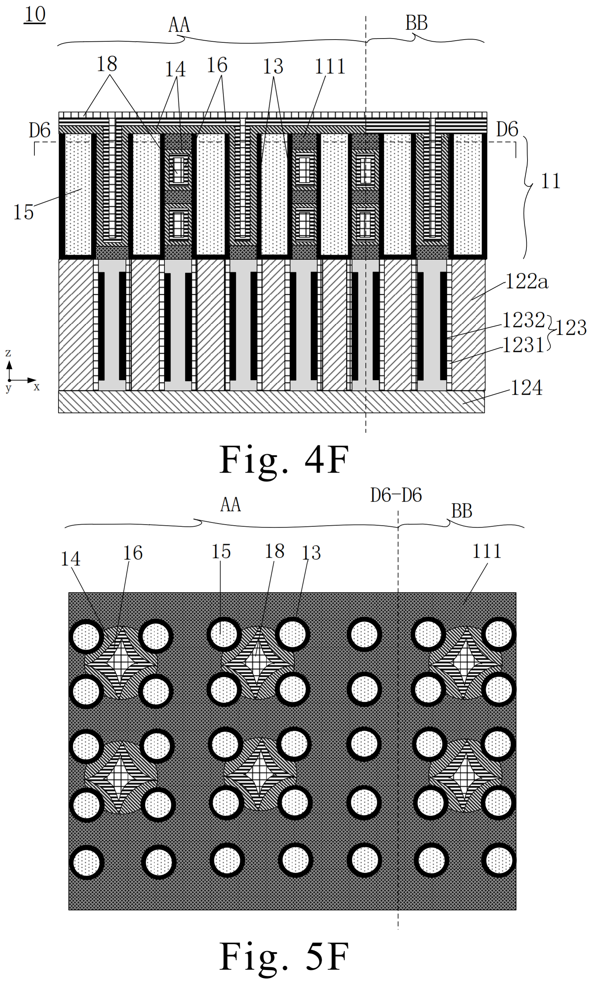

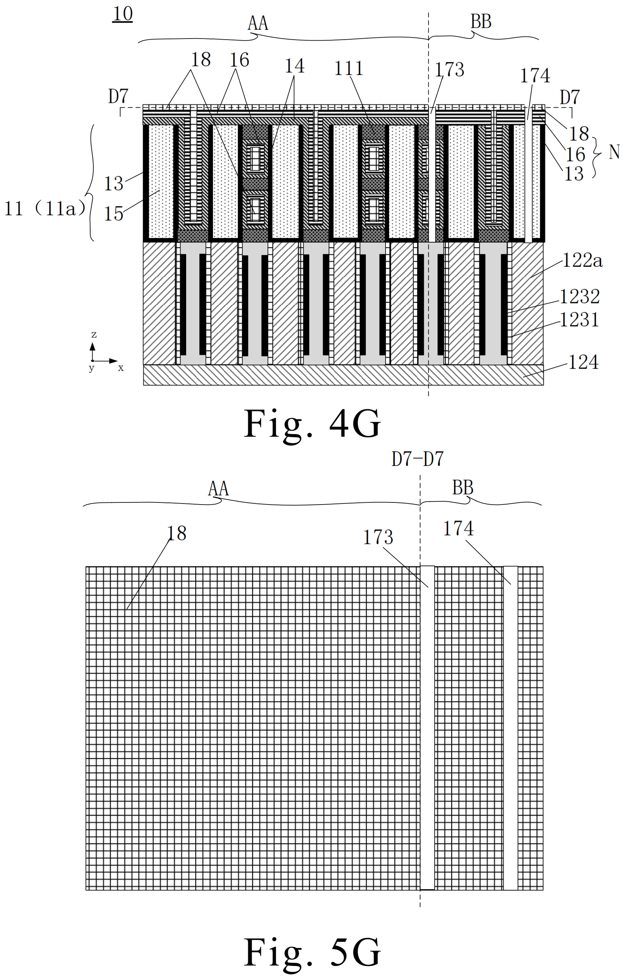

In some implementations, if the semiconductor structure 10 includes pillar-type capacitive structures, with reference to Figs. 4D to 4G and Figs. 5E to 5G (Fig. 5E being a cross-sectional structural diagram taken along the D5-D5 line in Fig. 4E, Fig. 5F being a cross-sectional structural diagram taken along the D6-D6 line in Fig. 4F and Fig. 5G being a cross-sectional structural diagram taken along the D7-D7 line in Fig. 4G), the above-mentioned operation S105 may include:
forming a second electrode layer 16 on a side of the stack of layers 11, the second electrode layer 16 covering the dielectric layer 14 on the side away from the stack of layers 11 in the cavities Q3 and the spacer holes Q2 and covering the exposed first electrode layer 13; and
forming a third trench 173 extending through the second electrode layer 16 on the stack of layers 11 in the stacking direction z and extending in the first direction x, the third trench 173 separating the portion of the second electrode layer 16 in the first region AA from the portion of the second electrode layer 16 in the second region BB in the second direction y, the first direction x, the second direction y and the stacking direction z being perpendicular to each other.

Here, for pillar-type capacitive structures, since the portion of the dielectric layer 14 in the second region BB is only removed partially, the first electrode layer 13 in the second region BB is only exposed partially (only exposed at the tops of the capacitor holes Q1), and the portion of the second electrode layer 16 formed in second region BB is only in direct contact and connected with the portions of the first electrode layer 13 exposed in the second region BB. Therefore, the first electrode layer 13 and the second electrode layer 16 that are so connected will be short-circuited and thus electrically connected with each other when power is on later.

Meanwhile, the second electrode layer 16 is also filled into the cavities Q3 and the spacer holes Q2, i.e., the second electrode layer 16 exists not only on the top of the stack of layers 11 but also in the cavities Q3 and spacer holes Q2. In contrast to the cup-type capacitive structures without cavities Q3, the pillar-type capacitive structures have increased effective area of the second electrode layer 16 and in turn improved capacity of charge storage.

Similar to the function of the first trench 171 for the cup-type capacitive structures, the third trench 173 is configured to separate the second electrode layer 16 into two disconnected portions, so as to isolate the portion of the second electrode layer 16 in the first region AA and the portion of the second electrode layer 16 in the second region BB and to achieve electrical insulation therebetween.

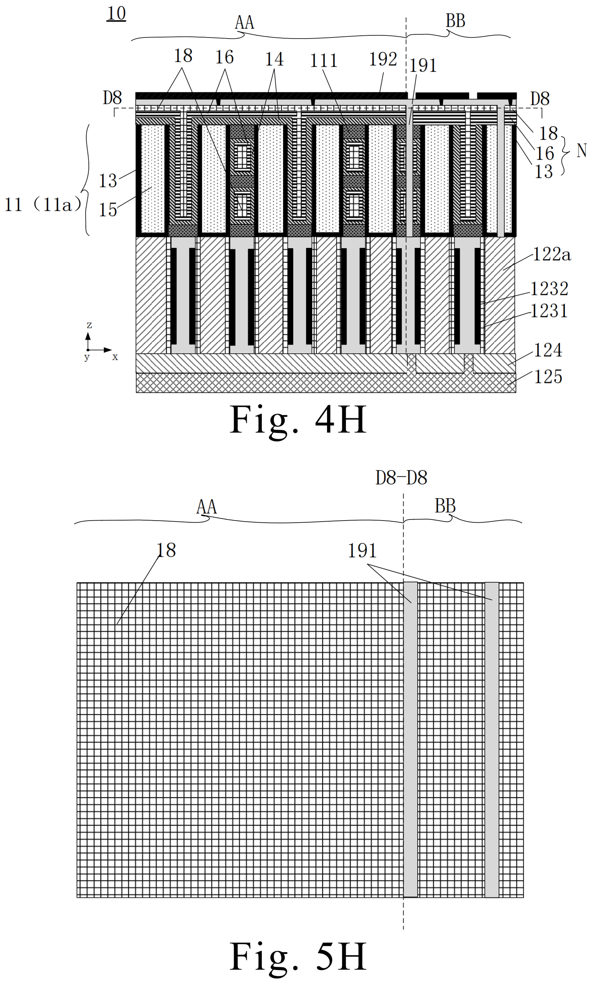

In some implementations, for pillar capacitive structures, with continued reference to Figs. 4E and 4H and Figs. 5E and 5F, the fabrication method may further include:
forming a semiconductor layer 18 on the side of the second electrode layer 16 away from the stack of layers 11, the semiconductor layer 18 filling up the cavities Q3 and the spacer holes Q2.

Here, the semiconductor layer 18 covers the second electrode layer 16 on the top of the stack of layers 11 in the first region AA and the second electrode layer BB and fills up the cavities Q3 and the spacer holes Q2. The semiconductor layer 18 may include at least one of polysilicon or silicide, for example, silicon germanium (SiGe). The third trench may be formed after formation of the semiconductor layer 18. Furthermore, since the semiconductor layer 18 is in direct contact (i.e., connected) with the second electrode layer 16, the third trench needs to extend at least through the semiconductor layer 18 and the second electrode layer 16 in the stacking direction z in order to separate the portion of the second electrode layer 16 in the second region BB from the portion of the second electrode layer 16 in the first region AA. Furthermore, if the first electrode layer 13 is further disposed at the corresponding locations of the third trench, the third trench needs to extend further through the first electrode layer 13.

In some implementations, for pillar capacitive structures, with reference to Figs. 4F and 4G and Fig. 5G, the fabrication method may further include:
forming a fourth trench 174 extending through the semiconductor layer 18 and the second electrode layer 16 in the stacking direction z to separate the second electrode layer 16 in the second region BB into multiple disconnected portions.

Herein, similar to function of the second trenches 172 for the cup-type capacitive structures, the fourth trench 174 is configured to separate the second electrode layer 16 in the second region BB into multiple disconnected portions. Furthermore, if the first electrode layer 13 is further disposed at the location of the fourth trench 174, the fourth trench 174 need to extend further through the first electrode layer 13.

Any one of the portions of the second electrode layer 16 formed by separating in the second region BB is connected with corresponding separated first electrode layer 13 and semiconductor layer 18. The first electrode layer 13, the second electrode layer 16 and the semiconductor layer 18 that are connected as a whole may serve as a contact structure N, so that multiple contact structures N are obtained with each of them extending through the stack of layers 11 in the stacking direction z.

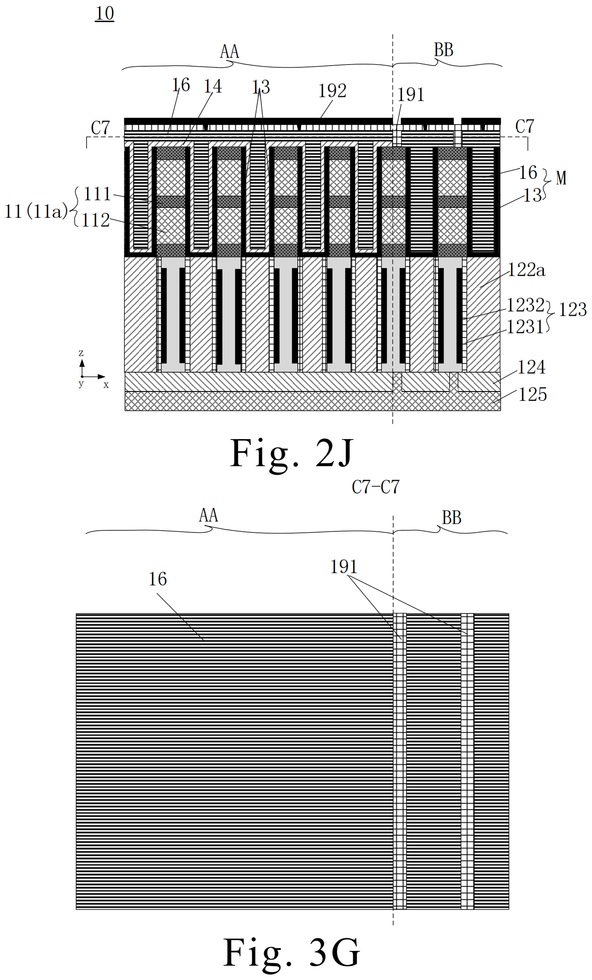

In some implementations, if the semiconductor structure 10 includes cup-type capacitive structures, further refer to Fig. 2I, Fig. 2J and Fig. 3G, Fig. 3G being a cross-sectional structural diagram taken along the C7-C7 line in Fig. 2J. Herein, after formation of the first trench 171 and the second trenches 172, a first insulating layer 191 is formed on a side of second electrode layer 16 away from the stack of layers 11, the first insulating layer 191 filling up the first trench 171 and the second trenches 172. Thereafter, a lead-out wiring 192 is formed on the side of the first insulating layer 191 away from the second electrode layer 16 and extends through the first insulating layer 191 in the stacking direction z to reach and thus be electrically connected with the second electrode layer 16.

If the semiconductor structure 10 includes pillar-type capacitive structures, refer to Fig.4G, Fig 4H and Fig. 5H, Fig. 5H being a cross-sectional structural diagram taken along the D8-D8 line in Fig. 2H. Herein, after formation of the third trench 173 and the fourth trench 174, a first insulating layer 191 may be further formed on the side of the semiconductor layer 18 away from the stack of layers 11, the first insulating layer 191 filling up the third trench 173 and the fourth trench 174. Thereafter, a lead-out wiring 192 is formed on the side of the first insulating layer 191 away from the semiconductor layer 18 and extends through the first insulating layer 191 in the stacking direction z to reach and thus be electrically connected with the semiconductor layer 18.

Herein, the first insulating layer 191 may include oxide, for example, silicon dioxide. The lead-out wiring 192 may include a conductive material, for example, copper. The lead-out wiring 192 may be configured to connect an external host electrically and receive signals therefrom. Similar to the second electrode layer 16, the lead-out wiring 192 may include multiple disconnected portions and this can be considered as the lead-out wiring 192 being separated into individual portions. The disconnected portions of the second electrode 16 (or the disconnected portions of the semiconductor layer 18) may be electrically connected with the corresponding disconnected portions of the lead-out wiring 192.

In some implementations, if the semiconductor layer 10 includes cup-type capacitive structures or pillar-type capacitive structures, with continued reference to Figs. 2J and 4H, after formation of the lead-out wiring 192, a plurality of trenches are formed to extend through the bit lines 124 in the stacking direction z to separate each bit line 124 into multiple disconnected portions, namely to separate the bit line 124 internally. The multiple disconnected portions of the bit line 124 are separated from each other at the locations corresponding to those locations, at which the second electrode layer and the semiconductor layer 18 are disconnected, so that each single contact structure M or N can be controlled independently. Thereafter, a second insulating layer 125 is formed on the side of the bit line 124 away from the channel structures 122a, the second insulating layer 125 filling up the trenches in the bit lines 124. The second insulating layer 125 may include oxide, for example, silicon dioxide.

For example, if the semiconductor structure 10 includes cup-type capacitive structures, with continued reference to Fig. 2J, the locations and number of the trenches formed in each bit line 124 correspond to those of the first trench 171 and the second trenches 172 in Fig. 2I. If the semiconductor structure 10 includes pillar-type capacitive structures, with continued reference to Fig. 4H, the locations and number of the trenches formed in each bit line 124 correspond to those of the third trench 173 and the fourth trench 174 in Fig. 3G.

In some implementations, other than the scheme of forming the plurality of trenches extending through the bit lines 124 in the stacking direction z after formation of the lead-out wiring 192, the plurality of trenches extending through the bit lines 124 in the stacking direction z may be formed after formation of the bit lines 124. There is no limitation in this respect. Examples of the present application further provide a semiconductor structure 10 including cup-type capacitive structures or pillar-type capacitive structures. With continued reference to Fig. 2J, Fig. 3G, Fig. 4H and Fig. 5H, the semiconductor structure 10 includes: a stack structure 11a including a first region AA and a second region BB; the first electrode layer 13 located in the first region AA and the second region BB, the first electrode layer 13 extending through the stack structure 11a in the stacking direction z and being separated into individual portions; a dielectric layer 14 located at least in the first region AA; and a second electrode layer 16 located in the first region AA and the second region BB, wherein the portion of the second electrode layer 16 in the first region AA is separated from the portion of the second electrode layer 16 in the second region BB, in the second region BB the first electrode layer 13 is connected with the second electrode layer 16, and in the first region AA the first electrode layer 13 and the second electrode layer 16 have the dielectric layer 14 disposed therebetween.

Here, the first direction x and the second direction y may be the directions, in which the stack of layers 11 extend, and are perpendicular to the stacking direction z of the stack of layers 11. The first region AA is the region corresponding to a memory array and the second region BB is used for another purpose. They may adjoin each other, e.g., the second region BB surrounds the first region AA. The first electrode layer 13 includes metal or any other conductive material, such as tungsten or copper. The material of the dielectric layer 14 may have a high dielectric constant. The second electrode layer 16 includes mainly a conductive material, such as any one or combination of tungsten, cobalt, copper, aluminum, polysilicon or doped crystal silicon.

The portion of the second electrode layer 16 in the first region AA is separated from the portion of the second electrode layer 16 in the second region BB, which mainly means that the portion of the second electrode layer 16 in the first region AA is disconnected with the portion of the second electrode layer 16, i.e., there is no contact area therebetween. In the second region BB the first electrode layer 13 is connected with the second electrode layer 16, which mainly means that the first electrode layer 13 in the second region BB is in direct contact with the second electrode layer 16 in the second region BB in at least some areas.

The first electrode layer 13 in the first region AA is separated and so is the first electrode layer 13 in the second region BB, i.e., the first electrode layer 13 in the first region AA and the first electrode layer 13 in the second region BB both include multiple segmented parts, which are disconnected to each other.

In some implementations, if the semiconductor structure 10 includes cup-type capacitive structures, with continued reference to Figs. 2J and 3G, the stack of layers 11 may include alternating spacer layers 111 and sacrificial layers 112. The sacrificial layers 112 may include silicon dioxide and the spacer layers 111 may include silicon nitride.

In some implementations, if the semiconductor structure 10 includes cup-type capacitive structures, with continued reference to Figs. 2J and 3G, the dielectric layer is located over the stack structure in the first region and covers the first electrode layer in the first region on the side away from the stack structure; and the second electrode layer is located over the stack structure in the first region and the second region and covers the dielectric layer in the first region on the side away from the first electrode layer and the first electrode layer in the second region on the side away from the stack structure.

In some implementations, if the semiconductor structure 10 includes cup-type capacitive structures, with continued reference to Figs. 2J and 3G, the semiconductor structure 10 may further include a supporting layer 15 having some portions in the first region AA and the other portions in the second region BB that are separated from each other. The first electrode layer 13 surrounds the supporting layer 15.

The material of the supporting layer 15 is different from that of the stack structure 11a and may be, for example, carbon.

In some implementations, if the semiconductor structure 10 includes pillar-type capacitive structures, with continued reference to Figs. 4G and 5G, the dielectric layer 14 is located over the stack structure 11a in the first region AA and extends through portions of the stack structure 11a in the first region AA and the second region BB in the stacking direction z; and the second electrode layer 16 is located over the stack structure 11a in the first region AA and the second region BB and covers the dielectric layer 14 on the side away from the first electrode layer 13.

In some implementations, if the semiconductor structure 10 includes pillar-type capacitive structures, with continued reference to Figs. 4G and 5G, the stack structure 11a includes multiple stacked spacer layers 111 that are separated from each other in the stacking direction z. The dielectric layer 14 and the second electrode layer 16 are also located between every two spacer layers 111 adjacent in the stacking direction z in the second region BB and the first region AA.

In some implementations, if the semiconductor structure 10 includes pillar-type capacitive structures, with continued reference to Figs. 4G and 5G, the semiconductor structure 10 may further include a semiconductor layer 18 located on the side of the second electrode layer 16 away from the dielectric layer 14 in the first region AA and the second region BB; between every two adjacent spacer layers 111, the second electrode layer 16 surrounds the semiconductor layer 18; and the portion of the semiconductor layer 18 in the first region AA is separated from the portion of the semiconductor layer 18 in the second region BB. The semiconductor layer 18 in the second region BB is separated internally.

Herein, the semiconductor layer 18 may include at least one of polysilicon or silicide, for example, silicon germanium (SiGe). The portion of the semiconductor layer 18 in the first region AA is separated from the portion of the semiconductor layer 18 in the second region BB, which means that they are disconnected, i.e., not in direct contact with each other. The portion of the semiconductor layer 18 in the second region BB are separated internally, which means that the semiconductor layer 18 in the second region BB is separated into multiple parts that are disconnected, i.e., not in contact with each other.

In some implementations, if the semiconductor structure 10 includes cup-type capacitive structures or pillar-type capacitive structures, with continued reference to Figs. 2J and 3G, Fig. 4G and Fig. 5G, the semiconductor structure 10 may further include channel structures 122a and gate structures 123, wherein the channel structures 122a are separated from each other in the first direction x and the second direction y and disposed on the side of the stack structure 11a away from the second electrode layer 16 and each of the gate structures 123 extends in the second direction y and is at least connected with the corresponding channel structure 122a in the first region AA.

The locations of the channel structures 122a correspond to those of the individual portions of the first electrode layer 13. The first direction x, the second direction y and the stacking direction z are perpendicular to each other. Each of the gate structures 123 may include a gate spacer layer 1231 and a gate layer 1232. The gate spacer layer 1231 may include oxide or any other insulating material, and the gate layer 1232 may comprise any one or combination of tungsten, cobalt, copper, aluminum, polysilicon and doped crystal silicon. The gate structures 123 adjacent in the first direction x may be separated and thus electrically insulated from each other by the insulating material disposed therebetween.

It is to be noted that gate structures 123 may be formed at corresponding locations in both the first region AA and the second region BB or only at corresponding locations in the first region AA and the present application is not limited in this respect.

In some implementations, if the semiconductor structure 10 includes cup-type capacitive structures or pillar-type capacitive structures, with continued reference to Figs. 2J and 3G, Fig. 4G and Fig. 5G, the semiconductor structure 10 may further include bit lines 124 located over the channel structures 122a on the side away from the stack structure 11a and connected with the channel structures 122a.

In some implementations, if the semiconductor structure 10 includes cup-type capacitive structures or pillar-type capacitive structures, with continued reference to Figs. 2J and 3G, Fig. 4G and Fig. 5G, the doping concentration of the channel structures 122a in the second region BB is different from that of the channel structures 122a in the first region AA and in an example the former is larger than the later.

Herein, the larger the doping concentration is, the higher conductivity is. Therefore, the conductivity of the channel structures 122a in the second region BB is higher than that of the channel structures 122a in the first region AA.

It is to be noted that, if the semiconductor structure 10 includes cup-type capacitive structures, with continued reference to Figs. 2J and 3G, any one of the disconnected portions of the second electrode layer 16 in the second region BB is connected with corresponding separated first electrode layer 13. The first electrode layer 13 and the second electrode layer 16 that are connected as a whole may serve as a contact structure M, so that multiple contact structures M are obtained with each of them extending through the stack structure 11a to the channel structures 122a in the stacking direction z.

In some implementations, if the semiconductor structure 10 includes pillar-type capacitive structures, with continued reference to Figs. 4G and 5G, any one of the disconnected portions of the second electrode layer 16 in the second region BB is connected with corresponding separated first electrode layer 13 and semiconductor layer 18. The first electrode layer 13, the second electrode layer 16 and the semiconductor layer 18 that are connected as a whole may serve as a contact structure N, so that multiple contact structures N are obtained with each of them extending through the stack structure 11a to the channel structures 122a in the stacking direction z.

In some implementations, if the semiconductor structure 10 includes cup-type capacitive structures, with continued reference to Figs. 2J and 3G, the semiconductor structure 10 further includes a first insulating layer 191 and a lead-out wiring 192. Herein, the first insulating layer 191 is located on the side of the second electrode layer 16 away from the stack structure 11a and fills up the space between the two adjacent disconnected portions of the second electrode layer 16. The lead-out wiring 192 is located on the side of the first insulating layer 191 away from the second electrode layer 16 and extends through the first insulating layer 191 in the stacking direction z to reach and thus be electrically connected with the second electrode layer 16.

In some implementations, if the semiconductor structure 10 includes pillar-type capacitive structures, with continued reference to Figs. 4G and 5G, the semiconductor structure 10 further includes a first insulating layer 191 and a lead-out wiring 192. The first insulating layer 191 is located on the side of the second electrode layer 16 away from the stack structure 11a and fills up the space between the two adjacent disconnected portions of the second electrode layer 16. The lead-out wiring 192 is located on the side of the first insulating layer 191 away from the semiconductor layer 18 and extends through the first insulating layer 191 in the stacking direction z to reach and thus be electrically connected with the semiconductor layer 18.

Here, the first insulating layer 191 may include oxide, for example, silicon dioxide. The lead-out wiring 192 may include a conductive material, for example, copper. The lead-out wiring 192 may be configured to connect an external host electrically and receive signals therefrom. Similar to the second electrode layer 16, the lead-out wiring 192 may include multiple disconnected portions and this can be considered that the lead-out wiring 192 is separated into individual portions. The disconnected portions of the second electrode 16 (or the disconnected portions of the semiconductor layer 18) may be electrically connected with the corresponding disconnected portions of the lead-out wiring 192.

It should be understood that for the structures and fabrication processes of the components of the semiconductor structure 10 in examples of the present application, refer to the examples of the fabrication method of the semiconductor structure 10 described above and no repetitions will be made here.

In summary, in the semiconductor structure 10 and the method of fabricating a semiconductor structure 10 provided by examples of the present application, a plurality of capacitor holes Q1 are formed to extend through a stack of layers 11 in the stacking direction z, the stack of layers 11 includes a first area AA and a second area BB, and the plurality of capacitor holes Q1 are distributed in both the first area AA and the second area BB, so that serious effect of etching load may be prevented from occurring in the first region AA during formation of the capacitor holes Q1, and the uniformity in size of the capacitor holes Q1 in the first region AA can be ensured, avoiding under etching; and subsequently, first electrode layer 13 is formed over the inside walls of the capacitor holes Q1, a dielectric layer 14 is formed on the side of the stack of layers in the first region AA and the second region BB and then is at least partially removed in the second region BB, and a second electrode layer 16 is formed in the first region AA and the second region BB, with the portion of the second electrode layer 16 in the first region AA separated from the portion of the second electrode layer 16 in the second region BB, and in the second region BB the first electrode layer 14 connected with the second electrode layer 16. At one hand, capacitive structures that are uniform in size can be formed in the first region AA to improve their reliability and, at the other hand, the first electrode layer 13 and the second electrode layer 16 that are connected in the second region BB may serve as contact structures, so that there is no need to fabricate any additional contact structures, the fabrication process is simplified and the flexibility is improved.

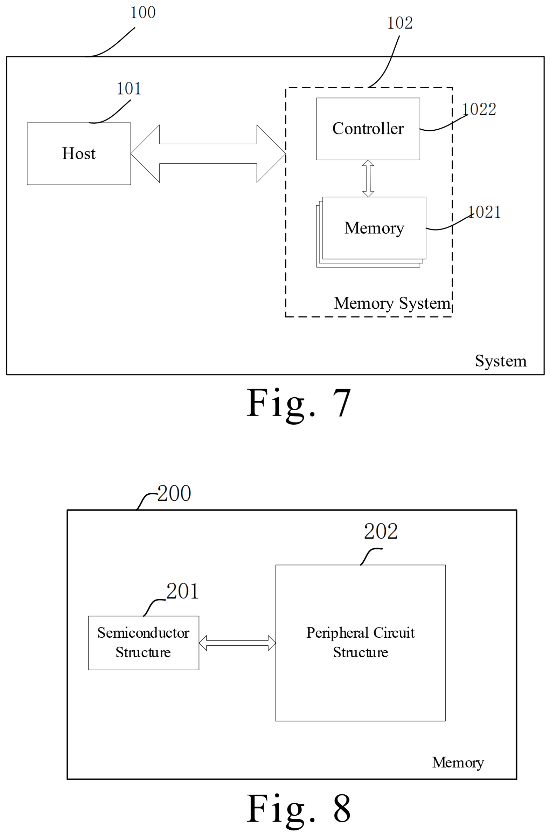

Furthermore, refer to Fig. 7, which is a structural diagram of an example system 100 provided in an example of the present application. The system 100 can be a mobile phone, a desktop computer, a laptop computer, a tablet, a vehicle computer, a gaming console, a printer, a positioning device, a wearable electronic device, a smart sensor, a virtual reality (VR) device, an augmented reality (AR) device, or any other suitable electronic device having storage therein. As shown in Fig. 7, the system 100 may include a host 101 and a memory system 102 including one or more memories 1021 and a controller 1022. The host 101 may be a processor of an electronic device, such as a central processing unit (CPU) or a memory system on chip (SOC) such as an application processor (AP). The host 101 may be configured to send data to the memory 1021 or receive data from the memory 1021.

In examples of the present application, the memory 1021 is not limited to a 3D DRAM memory and can be implemented as any one of various volatile memories that may lose the data stored therein when power is off, without deviating from the disclosure or teaching of the present application.

In some implementations, the controller 1022 is coupled to the memory 1021 and the host 101 and configured to control the memory 1021, e.g., to control the data write and read operations of the memory 1021. The controller 1022 can manage the data stored in the memory 1021 and communicate with the host 101.

The controller 1022 can be configured to control operations of the memory 1021, such as read, erase, and program operations. The controller 1022 can also be configured to manage various functions with respect to the data stored or to be stored in the memory 1021, including but not limited to bad-block management, garbage collection, logical-to-physical address conversion, wear leveling, etc.

The controller 1022 and the one or more memories 1021 can be integrated into various types of storage devices, for example, be included in the same package, such as a universal flash storage (UFS) package or an eMMC package. That is, the memory system 102 can be implemented and packaged into different types of electronic products.

Fig. 8 is a structural diagram of a memory 200 provided in an example of the present application. The memory 200 includes any semiconductor structure 201 described above and a peripheral circuit structure 202 coupled with the semiconductor structure 201. The peripheral circuit structure 202 may be configured to perform read, write, erase, verify and any other operations on the semiconductor structure 201.

In some implementations, the peripheral circuit structure 202 may further include a word line driver, a bit line driver, a column decoder, a sense circuit, a data buffer, a program verify logic, an erase verify circuit and the like, which can perform the above-mentioned operations according to the acquired computer program instructions.

It is noted that the peripheral circuit structure 202 and the semiconductor structure 201 may be arranged in a stack or side by side, without limitation here.

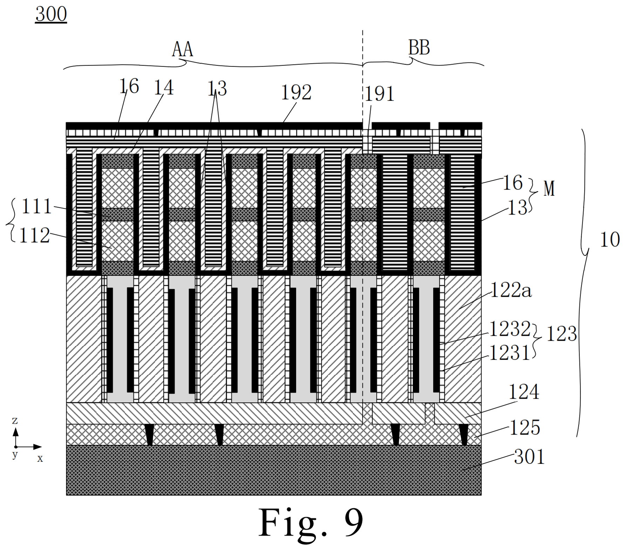

For example, with reference to Fig. 9, which is a cross-sectional structural diagram of a memory 300, the memory 300 includes a semiconductor structure 10 including any cup-type capacitive structures described above and a peripheral circuit structure 301 coupled with the semiconductor structure 10. The peripheral circuit structure 301 and the semiconductor structure 10 are stacked, with the peripheral circuit structure 301 located on the side of the second insulating layer 125 away from the bit lines 124 and electrically connected with the bit lines 124 through contacts.

What have been described above are only examples of the present application and not intended to limit the present application. Any modifications, equivalent substitutions and improvements made within the spirit and principle of the present application should be covered by the scope of the present application.

## Claims

1. A method of fabricating a semiconductor structure, comprising:
forming a plurality of capacitor holes extending through a stack of layers in a stacking direction, the stack of layers comprising a first region and a second region, and the capacitor holes being located in the first region and the second region;
forming a first electrode layer over the inside walls of the capacitor holes;
forming a dielectric layer on a side of the stack of layers in the first region and the second region;
removing at least part of the dielectric layer in the second region; and
forming a second electrode layer in the first region and the second region, a portion of the second electrode layer in the first region being separated from a portion of the second electrode layer in the second region, and in the second region the first electrode layer being connected with the second electrode layer.

2. The method of fabricating the semiconductor structure of claim 1, wherein the first electrode layer in both the first region and the second region is separated into individual portions.

3. The method of fabricating the semiconductor structure of claim 1, wherein the removing at least part of the dielectric layer in the second region comprises:
removing the dielectric layer in the second region to expose the first electrode layer in the second region.

4. The method of fabricating the semiconductor structure of claim 3, wherein the forming the second electrode layer in both the first region and the second region comprises:
forming the second electrode layer on the side of the stack of layers, the second electrode layer located in the first region and the second region, covering the dielectric layer on a side away from the stack of layers and the exposed first electrode layer, and filling up the capacitor holes; and
forming a first trench extending through the second electrode layer on the stack of layers in the stacking direction and extending in a first direction, the first trench separating the portion of the second electrode layer in the first region from the portion of the second electrode layer in the second region in a second direction, the first direction, the second direction and the stacking direction being perpendicular to each other.

5. The method of fabricating the semiconductor structure of claim 4, further comprising:
forming at least one second trench extending, in the stacking direction, through the portion of the second electrode layer on the stack of layers in the second region, the at least one second trench separating the second electrode layer in the second region into multiple disconnected portions.

6. The method of fabricating the semiconductor structure of claim 1, wherein the stack of layers comprises sacrificial layers and, before formation of the dielectric layer, the method further comprises:
forming a supporting layer on the side of the stack of layers in the first region and the second region with the supporting layer filling up the capacitor holes;
forming a plurality of spacer holes extending through the supporting layer into the stack of layers in the stacking direction, and removing the sacrificial layers to form cavities, the spacer holes being located in the first region and the second region; and
removing the portions of the supporting layer outside the capacitor holes,
wherein the dielectric layer is located on the stack of layers in the first region and the second region and covers the inside walls of the cavities and the spacer holes.

7. The method of fabricating the semiconductor structure of claim 6, wherein the removing at least part of the dielectric layer in the second region comprises:
removing the dielectric layer on the stack of layers in the second region and exposing a portion of the first electrode layer in the second region.

8. The method of fabricating the semiconductor structure of claim 7, wherein the forming the second electrode layer in the first region and the second region comprises:
forming the second electrode layer on the side of the stack of layers, the second electrode layer covering the dielectric layer on the side away from the stack of layers in the cavities and the spacer holes and covering the exposed first electrode layer; and
forming a third trench extending through the second electrode layer on the stack of layers in the stacking direction and extending in a first direction, the third trench separating the portion of the second electrode layer in the first region from the portion of the second electrode layer in the second region in a second direction, the first direction, the second direction and the stacking direction being perpendicular to each other.

9. The method of fabricating the semiconductor structure of claim 8, further comprising: forming a semiconductor layer on a side of the second electrode layer away from the stack of layers, the semiconductor layer filling up the cavities and the spacer holes;
wherein the third trench extends at least through the semiconductor layer and the second electrode layer in the stacking direction.

10. The method of fabricating the semiconductor structure of claim 9, further comprising:
forming a fourth trench extending through the semiconductor layer and the second electrode layer in the stacking direction, the fourth trench separating the second electrode layer in the second region into multiple disconnected portions.

11. The method of fabricating the semiconductor structure of any one of claims 1-10, further comprising:
forming a plurality of active parts extending in the first direction and spaced at an interval in the second direction on a substrate;
doping the active parts corresponding to the second region with a first concentration;
forming gate structures extending in the second direction and connecting at least the active parts in the first region, the gate structures extending through the active parts in the stacking direction and resulting in a plurality of channel structures, the first direction, the second direction and the stacking direction being perpendicular to each other; and
forming the stack of layers on a side of the substrate proximate to the channel structures.

12. The method of fabricating the semiconductor structure of claim 11, further comprising: doping the active parts in the first region with a second concentration that is lower than the first concentration.

13. A semiconductor structure, comprising:
a stack structure comprising a first region and a second region;
a first electrode layer located in the first region and the second region, the first electrode layer extending through the stack structure in the stacking direction and being separated into individual portions;
a dielectric layer located at least in the first region; and
a second electrode layer located in the first region and the second region, the portion of the second electrode layer in the first region being separated from the portion of the second electrode layer in the second region, in the second region the first electrode layer being connected with the second electrode layer, and in the first region the first electrode layer and the second electrode layer having the dielectric layer disposed therebetween.

14. The semiconductor structure of claim 13, wherein the first electrode layer in both the first region and the second region is separated into individual portions.

15. The semiconductor structure of claim 13, wherein the second electrode layer in the second region is separated into individual portions.

16. The semiconductor structure of claim 13, wherein the dielectric layer is located over the stack structure in the first region and covers the first electrode layer in the first region on a side away from the stack structure; and the second electrode layer is located over the stack structure in the first region and the second region and covers the dielectric layer in the first region on a side away from the first electrode layer and the first electrode layer in the second region on the side away from the stack structure.

17. The semiconductor structure of claim 13, the dielectric layer is located over the stack structure in the first region and extends through portions of the stack structure in the first region and the second region in the stacking direction; and the second electrode layer is located over the stack structure in the first region and the second region and covers the dielectric layer on the side away from the first electrode layer.

18. The semiconductor structure of claim 17, wherein the stack structure comprises multiple stacked spacer layers, and the dielectric layer and the second electrode layer are also located between every two spacer layers adjacent in the stacking direction in the second region and the first region.

19. The semiconductor structure of claim 18, further comprising a semiconductor layer located on the side of the second electrode layer away from the dielectric layer in the first region and the second region, wherein between every two adjacent spacer layers in the stacking direction, the second electrode layer surrounds the semiconductor layer, and the portion of the semiconductor layer in the first region is separated from the portion of the semiconductor layer in the second region.

20. The semiconductor structure of claim 19, wherein the semiconductor layer in the second region is separated into individual portions.

21. The semiconductor structure of claim 13, further comprising a supporting layer located in the first region and the second region and having individual portions separated from each other, the first electrode layer surrounding the supporting layer.

22. The semiconductor structure of any one of claims 13-21, further comprising channel structures and gate structures, wherein the channel structures are separated from each other in the first direction and the second direction and disposed on the side of the stack structure away from the second electrode layer, and each of the gate structures extends in the second direction and is at least connected with the corresponding channel structure in the first region; and
wherein the locations of the channel structures correspond to those of the individual portions of the first electrode layer, and the first direction, the second direction and the stacking direction are perpendicular to each other.

23. The semiconductor structure of claim 22, wherein the doping concentration of the channel structures in the second region is different from that of the channel structures in the first region, and the former is larger than the later.

24. A memory, comprising:
a semiconductor structure, comprising:
a stack structure comprising a first region and a second region;
a first electrode layer located in the first region and the second region, the first electrode layer extending through the stack structure in the stacking direction and being separated into individual portions;
a dielectric layer located at least in the first region; and
a second electrode layer located in the first region and the second region, the portion of the second electrode layer in the first region being separated from the portion of the second electrode layer in the second region, in the second region the first electrode layer being connected with the second electrode layer, and in the first region the first electrode layer and the second electrode layer having the dielectric layer disposed therebetween; and
a peripheral circuit structure electrically connected with the semiconductor structure.

25. A memory system, comprising:
at least one memory, each comprising:
a semiconductor structure, comprising:
a stack structure comprising a first region and a second region;
a first electrode layer located in the first region and the second region, the first electrode layer extending through the stack structure in the stacking direction and being separated into individual portions;
a dielectric layer located at least in the first region; and
a second electrode layer located in the first region and the second region, the portion of the second electrode layer in the first region being separated from the portion of the second electrode layer in the second region, in the second region the first electrode layer being connected with the second electrode layer, and in the first region the first electrode layer and the second electrode layer having the dielectric layer disposed therebetween; and
a peripheral circuit structure electrically connected with the semiconductor structure; and
a controller coupled with the at least one memory and configured to control the memory to store data.
